# EUROPEAN PATENT APPLICATION

(11) **EP 2 890 228 A1**
(43) Date of publication of application: **01.07.2015**
(21) Application number: 14197998.9
(22) Date of filing: 15.12.2014
(51) Int. Cl.: H05K 7/20

(54) **Radiation apparatus**

(30) Priority: 24.12.2013 KR 20130161997; 15.04.2014 KR 20140044682
(71) Applicant: Samsung Electronics Co., Ltd, Gyeonggi-do 443-742 (KR)
(72) Inventor: Kim, Jung Kyun, Gyeonggi-do (KR); Lee, Dong Gyu, Gyeonggi-do (KR); Heo, Do Won, Gyeonggi-do (KR)
(74) Representative: Appleyard Lees

(57) **Abstract**

Disclosed herein is a radiation apparatus provided with a case provided with an inner space and a vent configured to connect the inner space to an outside space and an air circulation unit provided with a vibrating plate configured to vibrate inside the case and configured to flow air by alternately expanding and contracting the inner space by a vibration of the vibrating plate.

## Description

### BACKGROUND

### 1. Field

Embodiments of the present disclosure relate to a radiation apparatus, and more particularly, a radiation apparatus having an improved radiation efficiency.

### 2. Description of Related Art.

In general, electronics have reduced in size, various components inside the electronics have been integrated, and performance has increased. Therefore, a key to smooth operation of the electronics is smoothly discharging heat generated by the components inside the apparatus.

Therefore, a radiation apparatus configured to radiate heat generated by a heating element is needed.

Cooling fans and radiation fins may be employed as a radiation apparatus, but space usage needs to be reduced and heat radiation efficiency is reduced.

### SUMMARY

Therefore, it is an aspect of the present disclosure to provide a radiation apparatus having improved radiation efficiency and reduced noise.

Additional aspects of the present disclosure will be set forth in part in the description which follows and, in part, will become apparent from the description, or may be learned by practice of the disclosure.

According to an aspect of the present disclosure, a radiation apparatus may include a case provided with an inner space and a vent configured to connect the inner space to an outside space, and an air circulation unit provided with a vibrating plate configured to vibrate inside the case, and configured to flow air by alternately expanding and contracting the inner space by a vibration of the vibrating plate.

The air circulation unit may include a magnetic circuit unit installed inside the case and configured to generate a magnetic force, and a coil provided on the vibrating plate and configured to vibrate the vibrating plate by an advance and retreat movement in accordance with the magnetic force.

The inner space may include a first inner space disposed on one side of the vibrating plate and a second inner space disposed on the other side of the vibrating plate, the vibrating plate dividing the first inner space and the second inner space.

The first inner space and the second inner space may be alternately contracted and expanded by the vibration of the vibrating plate.

The vent may include a first vent configured to connect the first inner space to the outside space and a second vent configured to connect the second inner space with the outside space wherein the first vent and the second vent are spaced apart from each other.

The first vent and the second vent may face a same direction.

The air circulation unit may include a piezoelectric device disposed on the vibrating plate and configured to vibrate the vibrating plate according to a contraction and an expansion of the piezoelectric device, which may be contracted or expanded according to an applied voltage.

The vent may include an air inlet disposed on one side of the case, and an air outlet disposed on the other side of the case.

The air circulation unit may include a supporting frame provided with a flow hole corresponding to the air outlet, disposed inside the case, and configured to support the vibrating plate.

The inner space may include a first inner space formed by the supporting frame and the vibrating plate, wherein air of the first inner space is discharged to the air outlet through the flow hole by the vibration of the vibrating plate.

The vibrating plate may be formed of plastic materials.

According to another aspect of the present disclosure, a device for radiating heat may include a frame defining a cavity, a first vent, and a second vent, and an air circulation unit comprising a vibration inducing unit configured to induce a diaphragm to move within the cavity in a first direction, and a second direction opposite the first direction.

The vibration inducing unit may include a magnetic circuit including a first coil located on the diaphragm and a second coil located on the frame, the second coil configured to receive an applied signal in order to generate a magnetic field.

The vibration inducing unit may include a piezoelectric device located on the diaphragm and configured to receive an applied signal and to contract and expand in a longitudinal direction according to the applied signal.

The air circulation unit may include a fixing frame configured to support the diaphragm, and a supporting frame defining a flow hole and configured to support the fixing frame.

The movement of the diaphragm may be configured to introduce air into an inner space between the supporting frame and the diaphragm by expanding the inner space, and to discharge air through the flow hole by contracting the inner space.

According to another aspect of the present disclosure, a method for radiating heat may include inducing a diaphragm to move in a first direction so as to introduce air into an inner space between a supporting frame and the diaphragm by expanding the inner space, and inducing the diaphragm to move in a second direction opposite the first direction so as to discharge air through the flow hole by contracting the inner space.

The movement in the first direction and the movement in the second direction may be induced by a piezoelectric device located on the diaphragm.

The movement in the first direction and the movement in the second direction may be induced by a magnetic circuit.

### BRIEF DESCRIPTION OF THE DRAWINGS

These and/or other aspects of the disclosure will become apparent and more readily appreciated from the following description of exemplary embodiments, taken in conjunction with the accompanying drawings, in which:
FIG. 1 is a perspective view illustrating a display unit according to an exemplary embodiment;
FIG. 2 is a perspective view illustrating a combination of the display unit and an auxiliary unit according to an exemplary embodiment;
FIG. 3 is an exploded view illustrating the auxiliary unit according to an exemplary embodiment;
FIG. 4 is a cross-sectional view illustrating the combination of the display unit and the auxiliary unit according to an exemplary embodiment;
FIG. 5 is a perspective view illustrating a radiation apparatus according to an exemplary embodiment;
FIG. 6 is an exploded view illustrating the radiation apparatus according to an exemplary embodiment;
FIG. 7 is a cross-sectional view of A-A' of FIG. 5;
FIGS. 8 and 9 are views illustrating an operation of the radiation apparatus according to an exemplary embodiment;
FIG. 10 is a view illustrating an arrangement of the radiation apparatus of the auxiliary unit according to an exemplary embodiment;
FIG. 11 is a perspective view illustrating a radiation apparatus according to an exemplary embodiment;
FIG. 12 is a front view illustrating a circuit board and a radiation apparatus according to an exemplary embodiment;
FIG. 13 is a front view illustrating a circuit board and a radiation apparatus according to an exemplary embodiment;
FIG. 14 is a perspective view illustrating a radiation apparatus according to an exemplary embodiment;
FIG. 15 is an exploded view illustrating the radiation apparatus according to an exemplary embodiment;
FIG. 16 is a cross-sectional view of B-B' in FIG. 14; and
FIGS. 17, 18, and 19 are views illustrating an operation of the radiation apparatus according to an exemplary embodiment.

### DETAILED DESCRIPTION OF EXEMPLARY EMBODIMENTS

The following detailed description is provided to assist the reader in gaining a comprehensive understanding of the methods, apparatuses, and/or systems described herein. However, various changes, modifications, and equivalents of the methods, apparatuses and/or systems described herein will be apparent to one of ordinary skill in the art. The progression of processing steps and/or operations described is an example; however, the sequence of and/or operations is not limited to that set forth herein and may be changed as is known in the art, with the exception of steps and/or operations necessarily occurring in a certain order. Also, descriptions of functions and constructions that are well known to one of ordinary skill in the art may be omitted for increased clarity and conciseness.

The features described herein may be embodied in different forms, and are not to be construed as being limited to the examples described herein. Rather, the examples described herein have been provided so that this disclosure will be thorough and complete, and will convey the full scope of the disclosure to one of ordinary skill in the art.

All terms including descriptive or technical terms which are used herein should be construed as having meanings that are obvious to one of ordinary skill in the art. However, the terms may have different meanings according to an intention of one of ordinary skill in the art, precedent cases, or the appearance of new technologies. Also, some terms may be arbitrarily selected by the applicant, and in this case, the meaning of the selected terms will be described in detail in the detailed description of the disclosure. Thus, the terms used herein have to be defined based on the meaning of the terms together with the description throughout the specification.

Also, when a part "includes" or "comprises" an element, unless there is a particular description contrary thereto, the part can further include other elements, not excluding the other elements. In the following description, terms such as "unit" and "module" indicate a unit for processing at least one function or operation, wherein the unit and the block may be embodied as hardware or software or embodied by combining hardware and software.

Throughout the specification, the term "application" indicates a group of computer programs designed to perform a specific work. Throughout the specification, the application may vary. For example, the application may include, but is not limited to, a web browser, a camera application, a dictionary application, a translation application, a data transmission application, a music reproduction application, a moving picture reproduction application, a message application, a social communication application, a social media application, a map application, a photo management application, a broadcasting application, a game application, an exercise support application, a payment application, a memo application, a calendar application, or a phone book application.

Reference will now be made in detail to exemplary embodiments of the present disclosure, examples of which are illustrated in the accompanying drawings. The drawings may not be to scale, and the relative size, proportions, and depiction of elements in the drawings may be exaggerated for clarity, illustration, and convenience.

As used herein, the term "and/or" includes any and all combinations of one or more of the associated listed items. Expressions such as "at least one of," when preceding a list of elements, should be understood to modify the entire list of elements and not as modifying the individual elements of the list.

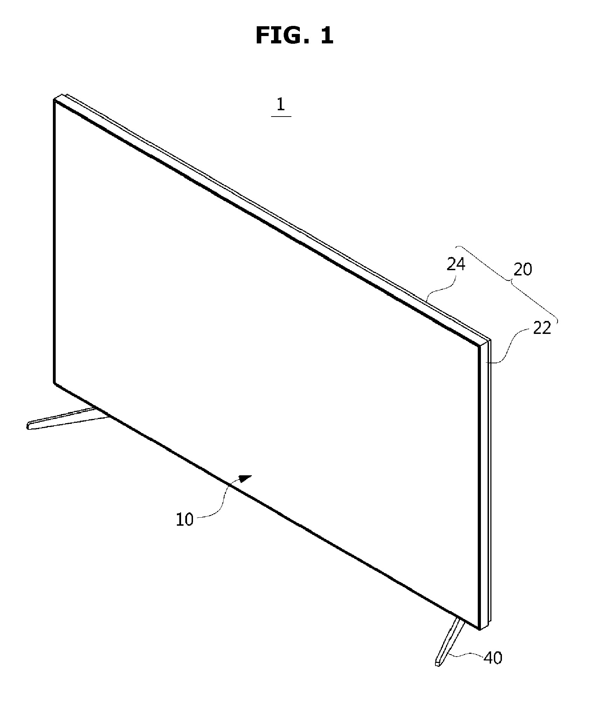

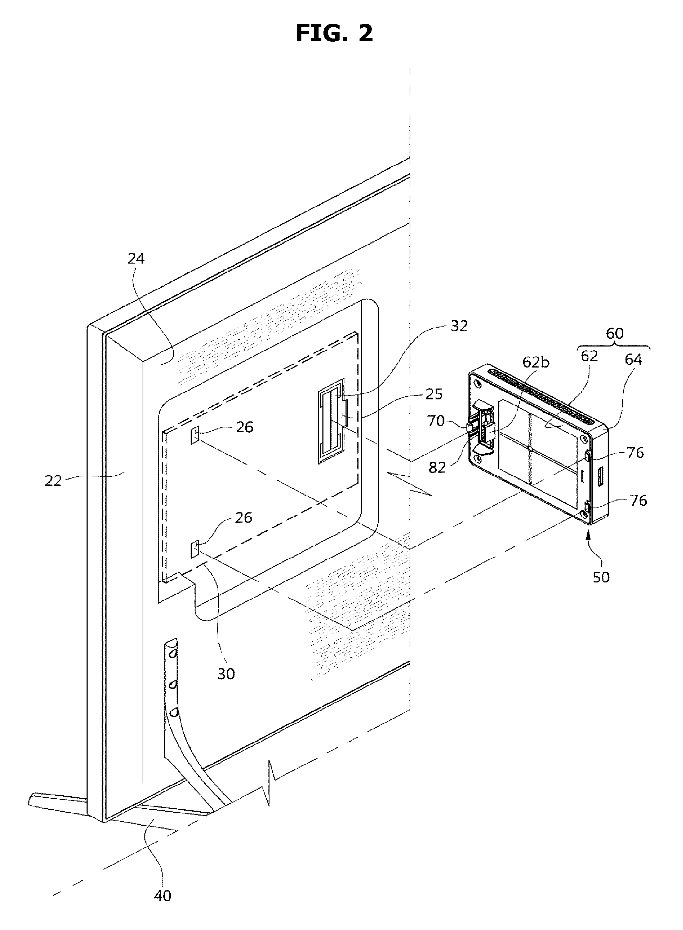

FIG. 1 is a perspective view illustrating a display unit according to an exemplary embodiment of the present disclosure and FIG. 2 is a perspective view illustrating a combination of the display unit and an auxiliary unit according to an exemplary embodiment. As one having ordinary skill in the art would appreciate, the type of electronic device is not meant to be limiting, and the display unit 1 is merely given as an example.

According to an aspect of an exemplary embodiment, the display unit 1 may be a Television (TV). The display unit 1 may include a display panel 10 configured to display images, and a unit body 20 in which the display panel is affixed.

The unit body 20 may include a side case 22 forming a side surface of the display unit 1, and a rear case 24 forming a rear surface of the display unit 1. The display unit 1 may further include a supporting leg 40 configured to support the unit body 20 from the support surface.

A main board 30 may include a basic circuit and electrical components of the display unit 1. The main board 30 may be disposed inside the unit body 20. The main board 30 may provide an execution environment of the display unit 1, and maintain the information to allow the display unit 1 to operate in a stable manner.

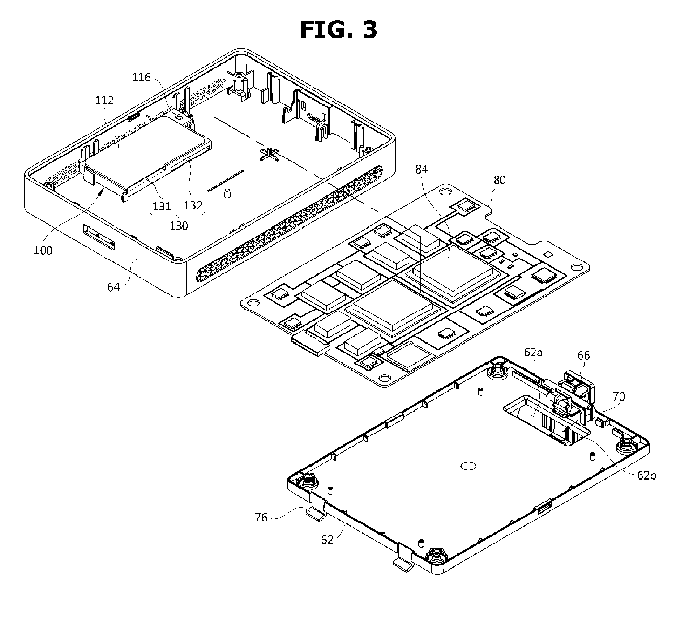

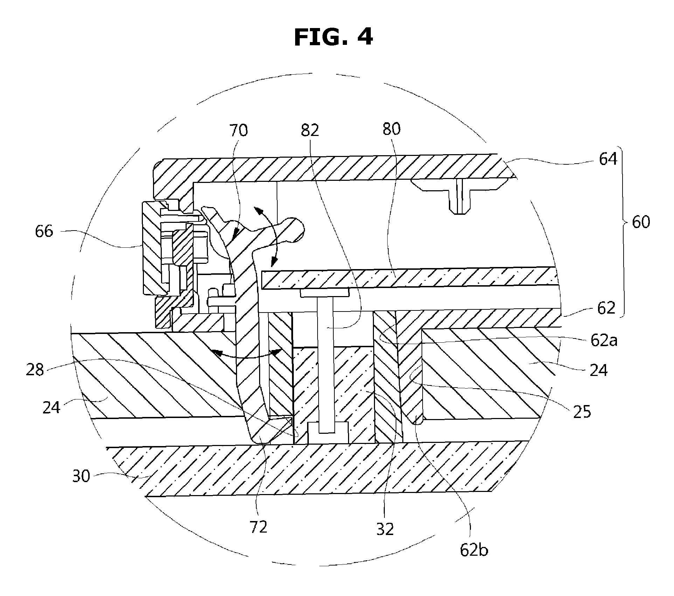

FIG. 3 is an exploded view illustrating the auxiliary unit according to an exemplary embodiment, and FIG. 4 is a cross-sectional view illustrating the combination of the display unit and the auxiliary unit according to an exemplary embodiment.

An auxiliary unit 50 may be detachably provided on the display unit 1.

The auxiliary unit 50 may be detachably provided on the display unit 1, and may be configured to upgrade electronic functions, or to upgrade software.

The auxiliary unit 50 may include an auxiliary unit body 60, and an auxiliary main board 80 disposed inside the auxiliary unit body 60 to be coupled to the main board 30 of the display unit 1. That is, the main board 30 may include a slot 32 so that the auxiliary main board 80 may be electrically coupled, and the auxiliary main board 80 may include a slot coupling unit 82. When the auxiliary unit 50 is coupled to the display unit 1, the slot coupling unit 82 of the auxiliary main board 80 may be coupled to the slot 32 of the main board 30 so that the main board 30 may be electrically coupled to the auxiliary main board 80.

The auxiliary unit body 60 may include an auxiliary lower case 62 facing the rear case 24 of the display unit 1, and an auxiliary upper case 64 coupled to the auxiliary lower case 62. The auxiliary lower case 62 may include a penetration flow hole 62a corresponding to the slot coupling unit 82, so that the slot coupling unit 82 may be exposed.

At least one locking leg 76 corresponding to at least one a locking flow hole 26 of the rear case 24 may be provided on one side of the auxiliary unit 50. An insertion flange 62b and a locking lever 70 may be provided on the other side of the auxiliary unit 50.

The locking leg 76 may be locked to the locking flow hole 26 so that one side of the auxiliary unit 50 may be affixed to the rear case 24.

The inserting flange 62b may be inserted into an inserting flow hole 25 of the rear case 24, and the locking lever 70 may be rotated so that a head part 72, provided on a portion of the locking lever 70, may be secured to the locking unit 28 of the rear case 24. Therefore, the other side of the auxiliary unit 50 may also be affixed to the rear case 24. By pressing a push button 66, the locking lever 70 may be moved to a position where the locking unit 28 is released from a constraint, and as a result of biasing provided by an elastic member (not shown), the locking lever 70 may return to an initial position.

Hereinafter, a radiation apparatus 100 will be described.

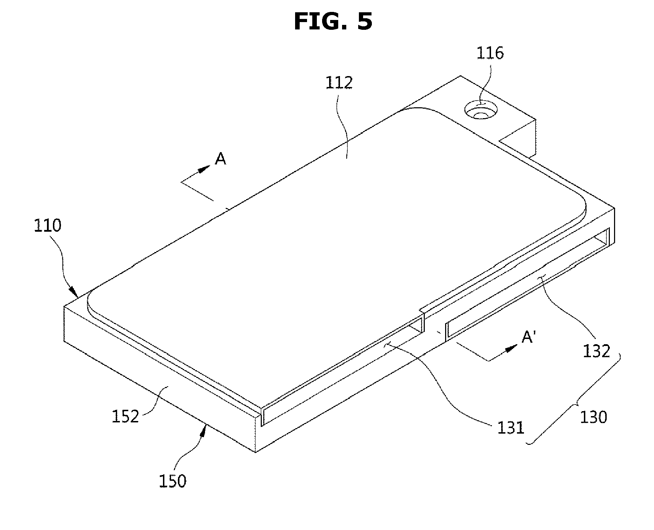

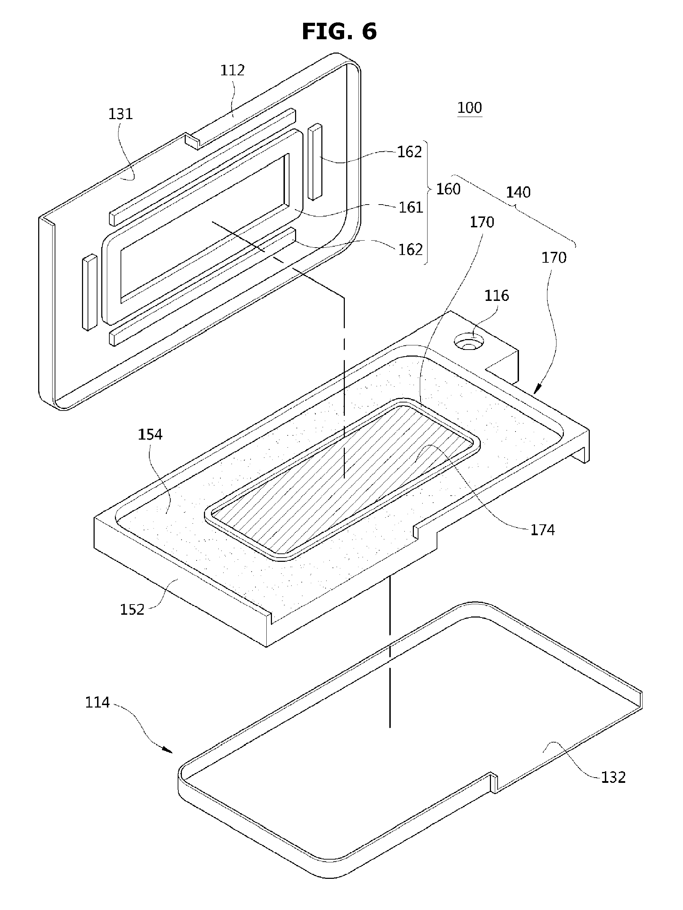

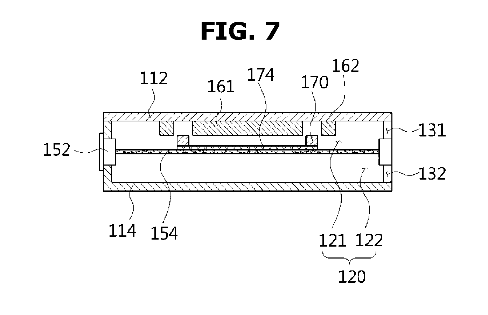

FIG. 5 is a perspective view illustrating a radiation apparatus according to an exemplary embodiment, FIG. 6 is an exploded view illustrating the radiation apparatus according to an exemplary embodiment, and FIG. 7 is a cross-sectional view of A-A' of FIG. 5.

The radiation apparatus 100 may be disposed adjacent to the auxiliary main board 80 so that heat generated by the heating element 84 of the auxiliary main board 80 may be cooled. According to an aspect of an exemplary embodiment, the radiation apparatus 100 is configured to affix to one side of the auxiliary upper case 64, so as to be adjacent to a circuit board, but is not limited hereto. According to an aspect of an exemplary embodiment, the radiation apparatus 100 may be disposed on the auxiliary main board 80.

The radiation apparatus 100 may include a case 110 and an air circulation unit 140.

The case 110 may form an external portion of the radiation apparatus 100, and may be disposed on the auxiliary main board 80, or on an inner surface of the auxiliary unit 50. According to an exemplary embodiment of the present disclosure, the case 110 may be disposed on an inner surface of the auxiliary unit 50. The case 110 may include a case fixing unit 116 to be mounted on the inner surface of the auxiliary unit 50. However, a position where arrangement of the case 110 is disposed is not limited thereto, and a vent 130, which will be described later, may be disposed so as to face the heating element 84. According to various aspects of exemplary embodiments, the radiation apparatus 100 may be screw-coupled to the auxiliary upper case 64 by the case fixing unit 116 disposed on the case 110. Alternatively, the radiation apparatus 100 may be fixed to the auxiliary upper case 64 by an adhesive of one side of the case 110. The technique of fixing the radiation apparatus 100 to the case 110 is not limited thereto.

The case 110 may include an upper case 112 and a lower case 114. A vibrating plate 150, which will be described later, may be disposed between the upper case 112 and the lower case 114.

The case 110 may include at least one vent 130. The vent 130 may connect an inner space 120 of the case 110 with the outside. The vent 130 will be described later in detail.

The air circulation 140 may be disposed inside the case 110 and configured to cool heat generated by the heating element 84 by introducing or discharging air from or to the outside through the vent 130.

The air circulation 140 may include the vibrating plate 150 configured to perform an advance and retreat movement inside the case 110. Air of an inner space 120 may be caused to flow in or flow out by movement of the vibrating plate 150.

The vibrating plate 150 may include a fixing frame 152 and a vibrating unit 154.

The fixing frame 152 may be formed along the periphery of the vibrating plate 150, and may be configured to be fixed to the case 110. Particularly, the fixing frame 152 may be fixed by being coupled between the upper case 112 and lower case 114.

The vibrating unit 154 may be provided inside the fixing frame 152, and may be caused to move in a first direction (w1), and a second direction (w2) opposite to the first direction (w1), by an external force.

The vibrating plate 150 may divide the inner space 120 into a first inner space 121 and a second inner space 122. Inside the case 110, the first inner space 121 may be provided on one side of the vibrating plate 150, and the second inner space 122 may located across the vibrating plate 150, so to be provided on the other side of the vibrating plate 150.

The vent 130 may include a first vent 131 and a second vent 132. The first vent 131 and the second vent 132 may, respectively, connect the first inner space 121 and the second inner space 122 with the outside.

According to an aspect of an exemplary embodiment, the first vent 131 and the second vent 132 may face the same direction and be spaced apart from each other, but is not limited hereto.

That is, the first vent 131 and the second vent 132 may be spaced apart from each other so that it may be possible to prevent the interference of the air flow inside the first inner space 121 and the second inner space 122, which have a different expansion and contraction according to a movement of the vibrating plate 150.

Particularly, according to an aspect of an exemplary embodiment, the first inner space 121 and the second inner space 122 may be vertically divided so that the first vent 131 and the second vent 132 may be horizontally spaced apart from each other.

An arrangement of the first vent 131 and the second vent 132 is not limited thereto.

The air circulation 140 may include a magnetic circuit unit 160 and a coil 170.

The magnetic circuit unit 160 may be disposed inside the case 110 and configured to generate a magnetic force.

The coil 170 may perform an advance and retreat movement by acting with the magnetic circuit unit 160, and may be disposed on the vibrating plate 150. The coil 170 may advance and retreat in the first direction (w1) and the second direction (w2) by a force generated by the magnetic force on the magnetic circuit unit 160 and an electric force flowing on the coil 170.

The coil 170 may be placed on a coil setting unit 174 provided in the vibrating unit 154. An arrangement of the coil 170 is not limited hereto, but the coil 170 may be disposed on the center of the vibrating unit 154 so that the vibrating unit 154 may be effectively vibrated.

The magnetic circuit unit 160 may include a first magnetic circuit unit 161 disposed inside the coil 170 and a second magnetic circuit unit 162 disposed outside the coil 170. The coil 170 may perform an advance and retreat movement to be moved in or moved out between the first circuit unit 161 and the second circuit unit 162.

A terminal (not shown) of the coil 170 may be connected to the outside of the case 110 and configured to receive electric signals.

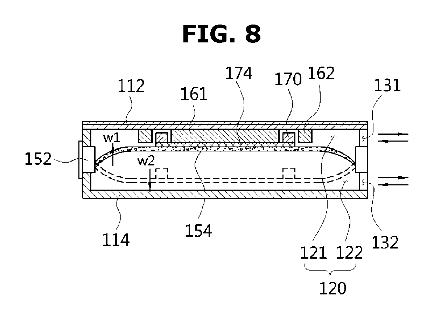

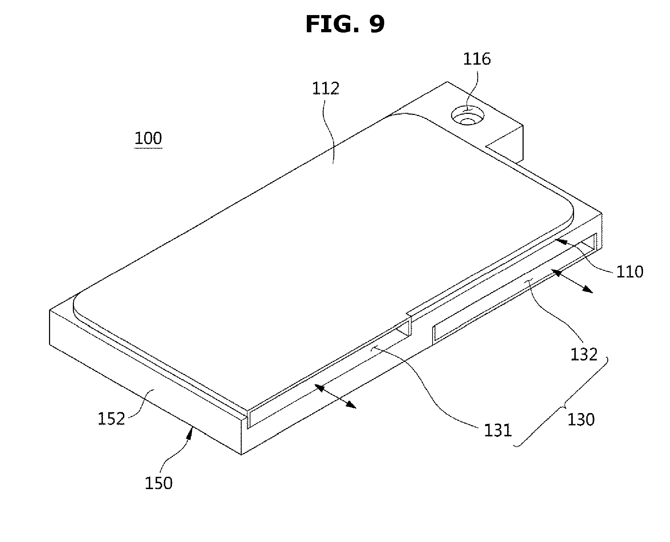

FIGS. 8 and 9 are views illustrating an operation of the radiation apparatus according to an exemplary embodiment.

When the coil 170 receives electric signals through the terminal (not shown), the electric signals may act with the magnetic force of the magnetic circuit unit 160 so that the coil 170 may advance and retreat in the first direction (w1) and the second direction (w2).

The coil 170 may be disposed on the vibrating unit 154 of the vibrating unit 150 so that the vibrating unit 154 may be vibrated in the first direction (w1) and the second direction (w2) according to the advance and retreat movement of the coil 170.

When the vibrating unit 154 is vibrated and moved in the first direction (w1), the first inner space 121 may be contracted so that an internal air may be discharged through the first vent 131. At the same time, the second inner space 122 may be expanded due to the contraction of the first inner space 121 so that an external air may be suctioned through the second vent 132.

When the vibrating unit 154 is vibrated and moved in the second direction (w2), the second inner space 122 may be contracted so that an internal air may be discharged through the second vent 132. At the same time, the first inner space 121 may be expanded due to the contraction of the second inner space 122 so that an external air may be suctioned through the first vent 131.

As described above, the internal air may be discharged to the outside through the first vent 131 and the second vent 132 so that the heating element 84 may be cooled.

The heating element 84 may be cooled by the vibration of the vibrating plate 150. Therefore, the inner space 120 may have a height corresponding to vibration amplitude of the first direction (w1) and the second direction (w2) of the vibrating plate 150 in order to realize a thinner heat radiation apparatus 100.

By the structure, the space utilization of the auxiliary unit 50 may be improved and power consumption and the size may be reduced when comparing with using a cooling fan. Noise generated by the radiation apparatus 500 may be minimized due to the miniaturization and the improved structure.

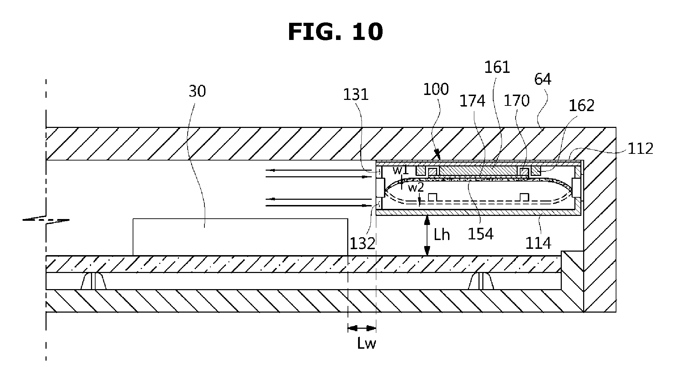

FIG. 10 is a view illustrating an arrangement of the radiation apparatus of the auxiliary unit according to an exemplary embodiment.

The radiation apparatus 100 may be spaced apart from the auxiliary main board 80 or the heating element 84 of the auxiliary main board 80. The radiation apparatus 100 may contract or expand the first inner space 121 and the second inner space 122 by the vibration of the vibrating plate 150 in order to cool the heating element 84. Therefore, when the vent 130 of the vibration apparatus 100 is proximate to the heating element 84, the flow of the external air and the internal air may be difficult and thus the auxiliary main board 80 of the radiation apparatus 100 and the heating element 84 of the auxiliary main board 80 may be spaced apart from each other.

According an exemplary embodiment, the radiation apparatus 100 may be horizontally spaced apart from the heating element 84 by distance Lw, and may be vertically spaced apart from the auxiliary main board 80 by distance Lh. Lw and Lh may be determined based on a size of the radiation apparatus 100, a radiating capacity of the radiation apparatus 100, and a calorific value of the heating element 84. According to an aspect of an exemplary embodiment, Lw may be approximately 2mm, and Lh may be approximately 2mm, but is not limited thereto.

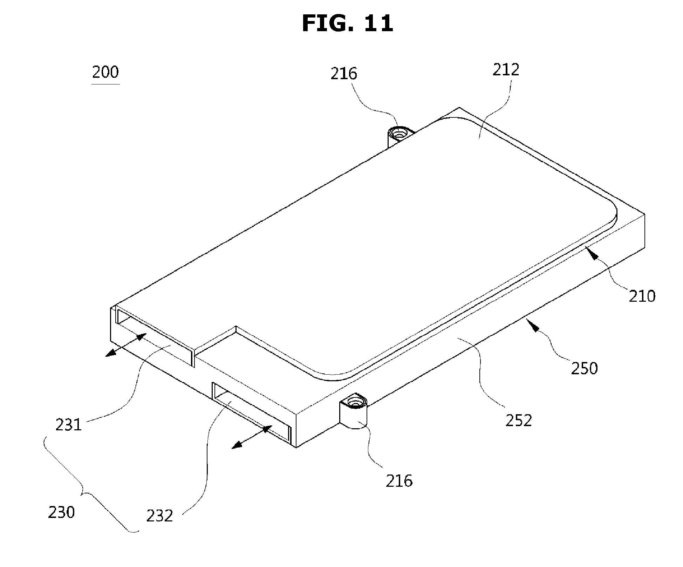

FIG. 11 is a perspective view illustrating a radiation apparatus according to an exemplary embodiment.

The radiation apparatus 200 according to an exemplary embodiment may be provided with a vent 230 disposed on a short side of the radiation apparatus 200.

The vent 230 may include a first vent 231 and a second vent 232, and may be disposed on a short side so that the vent 230 may be narrow compared with an inner space. , The relatively narrow vent 230 enables air to flow in or flow out at a higher velocity.

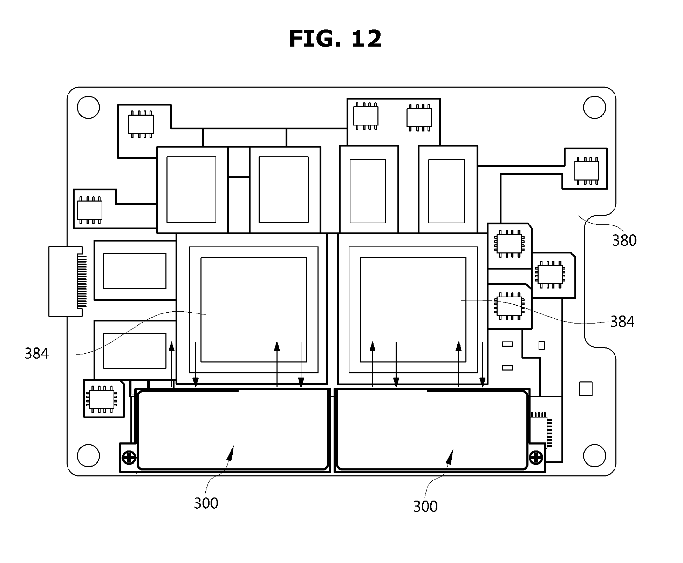

FIG. 12 is a front view illustrating a circuit board and a radiation apparatus according to an exemplary embodiment.

In an auxiliary main board 380 inside an auxiliary unit 50, a plurality of heating elements 384 may be provided. In the auxiliary unit 50, a plurality of radiation apparatuses 300 corresponding to the plurality of heating elements 384 may be provided.

The plurality of radiation apparatuses 300 may be arranged so as to correspond to the plurality of heating elements 384, and the plurality of radiation apparatuses 300 may be disposed in parallel to each other on one side of the plurality of heating elements 384 arranged in parallel to each other. A vent may be provided on a long side of the radiation apparatus 300 so that the vent may face the heating element 384.

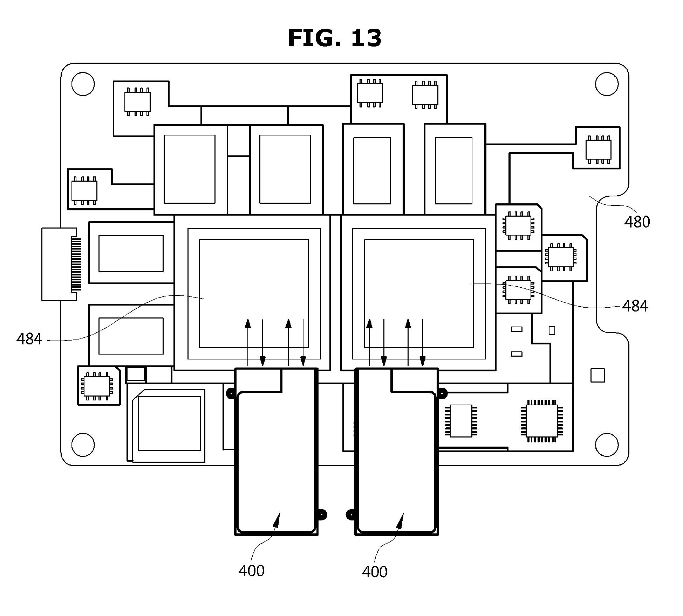

FIG. 13 is a front view illustrating a circuit board and a radiation apparatus according to an exemplary embodiment.

In an auxiliary main board 480 inside an auxiliary unit 50, a plurality of heating elements 484 may be provided. In the auxiliary unit 50, a plurality of radiation apparatuses 400 corresponding to the plurality of heating elements 484 may be provided.

The plurality of radiation apparatuses 400 may be arranged so as to correspond to the plurality of heating elements 484, and the plurality of radiation apparatuses 400 may be disposed in parallel to each other on one side of the plurality of heating elements 484 arranged in parallel to each other. A vent may be provided on a short side of the radiation apparatus 400 so that the vent may face the heating element 484.

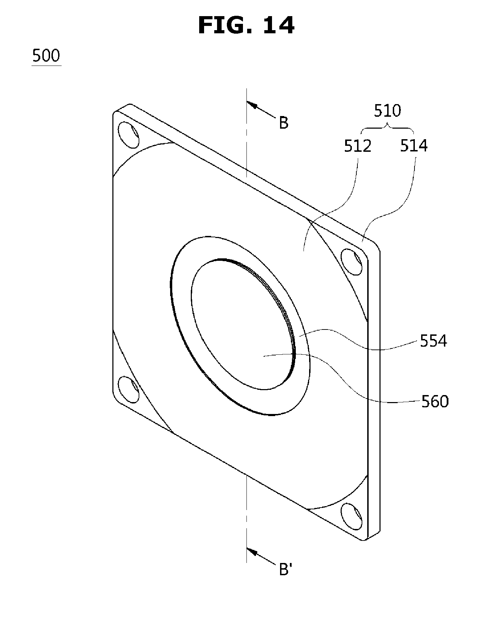

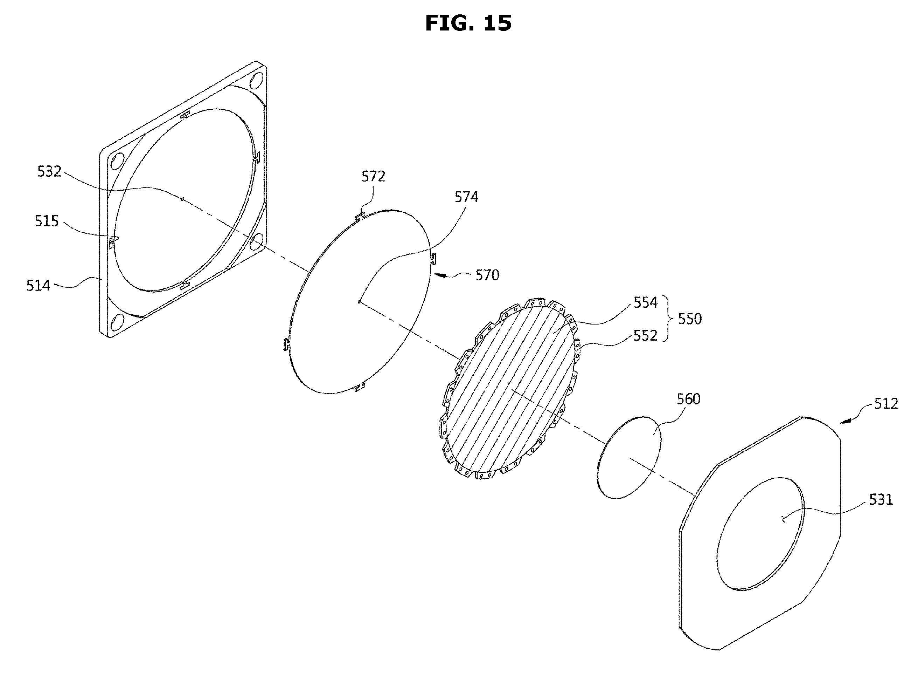

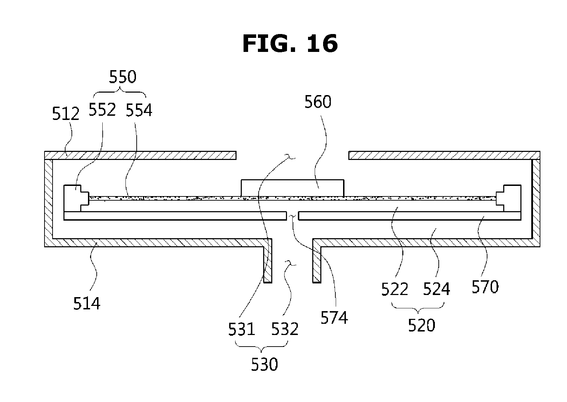

FIG. 14 is a perspective view, and FIG. 15 is an exploded view illustrating a radiation apparatus according to an exemplary embodiment of the present disclosure. FIG. 16 is a cross-sectional view of B-B' in FIG. 14.

The radiation apparatus 500 may include a case 510, and an air circulation unit 540.

The case 510 may form an external portion of the radiation apparatus 500, and may be disposed on an auxiliary main board 80 or on a main body.

The case 510 may include an upper case 512 and a lower case 514. The lower case 514 may be formed in a concave manner so that the air circulation unit 540, which will be described later, may be placed therein. In addition, one side of the lower case 514 may be open and configured to be closed by the upper case 512.

The air circulation unit 540 may be disposed inside the case 510 to cool heat generated by the heating element 84 by introducing or discharging air from or to the outside through a vent 530.

The air circulation 540 may include a vibrating plate 550 configured to perform an advance and retreat movement inside the case 510. Air of an inner space 520 may be flowed in or flowed out by the vibrating plate 550.

The vibrating plate 550 may include a fixing frame 552 and a vibrating unit 554. The fixing frame 552 may be formed along the periphery of the vibrating plate 550 and may be supported by a supporting frame 570, which will be described later. A thickness of the fixing frame 552 may be larger than that of the vibrating unit 554

The vibrating unit 554 may be provided inside the fixing frame 552, and may be vibrated in a first direction (w1), and a second direction (w2) opposite to the first direction (w1) by an external force. Particularly, the first direction (w1) may be described as the vibrating unit 554 is directed to an upper side and the second direction (w2) may be described as the vibrating unit 554 is directed to a lower side.

The fixing frame 552 may be formed in a ring shape, and the vibrating unit 554 may be formed in a circle shape inside the fixing frame 552, but a shape and an arrangement thereof are not limited hereto.

The supporting frame 570 may allow the fixing frame 552 to be placed inside the radiation apparatus 500.

An outline of the supporting frame 570 may be spaced apart from an inside of the lower case 514 with a certain distance, and may be formed to allow air introduced through an air inlet 531 of the upper case 512 to pass through.

The supporting frame 570 may include a fixing protrusion 572 forming along a circumference of the supporting frame 570 to fix to the lower case 514. The fixing protrusion 572 may correspond to a fixing groove 515 provided on the lower case 514 and may allow the supporting frame 570 to be placed on the lower case 514.

The supporting frame 570 may include a flow hole 574. Between the vibrating plate 550 and the supporting frame 570, a first inner space 522 may be provided for air to be circulated. Particularly, the fixing frame 553 may have a larger thickness than the vibrating unit 554 and thus the first inner space 522 may be formed due to a thickness difference between the fixing frame 552 and the vibrating unit 554. In the first inner space 522, air may flow in and flow out through the flow hole 574. When considering the first inner space 522, the flow hole 574 may be relatively small so that a pressure of air may become large when air is discharged through the flow hole 574. The flow hole 574 may be disposed on the center of the supporting frame 570.

The inner space 520 provided inside the case 510 may include the first inner space 522 formed by one side of the supporting frame 570 and the vibrating plate 550, and a second inner space 524 excluding the first inner space 522 in the inner space 520. When the vibrating unit 554 is operated in the first direction (w1), air inside the second inner space 524 may be introduced to the first inner space 522 through the flow hole 574, and when the vibrating unit 554 is operated in the second direction (w2), air may be discharged from the first inner space 522 through the flow hole 574. In this process, a pressure of the discharged air may be increased since the flow hole 574 may be relatively small when considering a size of the first inner space 522, and by the pressure, the air may be discharged to the outside of the radiation apparatus 500 through an air outlet 532 disposed on an extension line of the flow hole 574.

The case 510 may include at least one vent 530. The vent 530 may allow the inner space 520 of the case 510 to be connected with the outside.

The vent 530 may include the air inlet 531 and the air outlet 532 to allow the inner space 520 to be connected with the outside.

The air inlet 531 and the air outlet 532 may be disposed to face opposite directions, but an arrangement of the air inlet 531 and the air outlet 532 is not limited hereto.

The air inlet 531 may be formed along an ambient area of the vibrating plate 550 on the upper case 512, and the air outlet 532 may be formed on the lower case 514 to correspond to the center of the vibrating plate 550 to face the vibrating plate 550.

The air inlet 531 may be formed on the upper case 512 and the air outlet 532 may be formed on the lower case 514 to correspond to the center of the vibrating plate 550 to face the vibrating plate 550.

The air inlet 531 and the air outlet 532 may be formed on opposite sides of the case 510. The radiation apparatus 500 may be mounted to the auxiliary unit body 60 so that cool air outside the auxiliary unit body 60 may be introduced to the inside of the auxiliary unit body 60 and hot air inside the auxiliary unit body 60 may be discharged to the outside of the auxiliary unit body 60. In addition, the radiation apparatus 500 may be disposed on the auxiliary main board 80 so that the air outlet 532 may face the heating element 84 to directly cool the heating element 84.

According to an aspect of an exemplary embodiment, the air inlet 531 may be disposed to face the heating element 84 so that heat generated by the heating element 84 may be directly discharged to the outside.

Air introduced through the air inlet 531 may be introduced to the second inner space 524 through the inside of the upper case 512 and the inside of the lower case 514, and may be discharged through the air outlet 532 by an operation of the vibrating plate 550.

The air circulation unit 540 may include a piezoelectric device 560. The piezoelectric device 560 may be installed on the vibrating plate 550. Particularly, the piezoelectric device 560 may be installed on the vibrating unit 554. The piezoelectric device 560 may be configured to be contracted and expanded in a longitudinal direction according to a an applied voltage, and thus the vibrating plate 550 having the piezoelectric device 560 may be bent in a third direction and a fourth direction according to the contraction and expansion of the piezoelectric device 560.

For example, when the voltage is applied to one side of the piezoelectric device 560 installed on the vibrating unit 554, a length of the piezoelectric device 560 may be contracted and accordingly the vibrating unit 554 may be bent so as to be biased toward an upper side. On the contrary, when the current is applied to the other side of the piezoelectric device 560, a length of the piezoelectric device 560 may be expanded and accordingly the vibrating unit 554 may be bent so as to be biased toward a lower side. By repeatedly performing those operations, the vibrating unit 554 may vibrate.

The piezoelectric device 560 may be fixed to the vibrating unit 554 by using epoxy, but a technique of fixing the piezoelectric device 560 to the vibrating unit 554 is not limited hereto.

The vibrating plate 550 may be moved in the first direction (w1) and the second direction (w2) by the operation of the piezoelectric device 560. A terminal (not shown) of the piezoelectric device 560 may be connected to the outside of the case 510 and may be configured to receive electric signals.

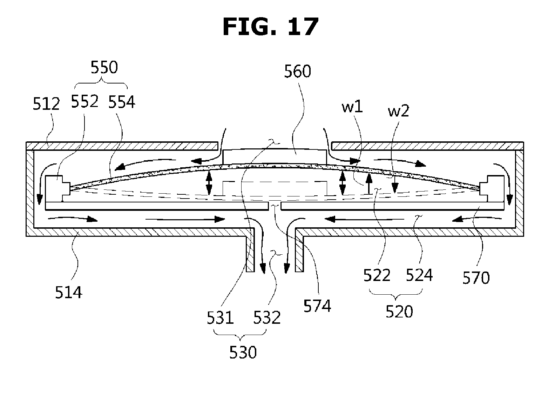

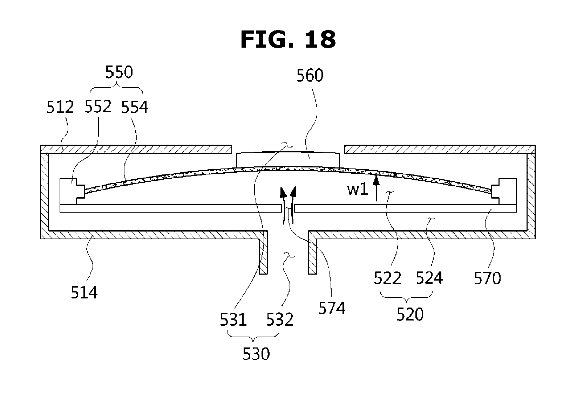

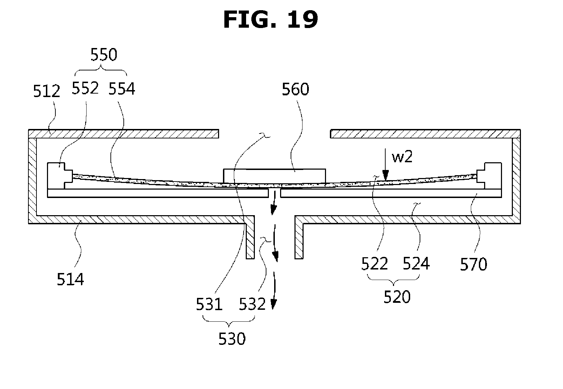

FIGS. 17, 18, and 19 are views illustrating an operation of the radiation apparatus according to an exemplary embodiment of the present disclosure.

When a coil receives electric signals through a terminal (not shown) the piezoelectric device 560 may be operated and the vibrating unit 554 may vibrate in the first direction (w1) and the second direction (w2).

When the vibrating unit 554 vibrates in the first direction (w1), the first inner space 522 may be expanded since the supporting frame 570 may be fixed. Accordingly, air in the second inner space 524 may be introduced to the first inner space 522 through the flow hole 574.

When the vibrating unit 554 vibrates in the second direction (w2), the first inner space 522 may be contracted since the supporting frame 570 may be fixed. Accordingly, air in the first inner space 522 may be discharged to the outside through the flow hole 574. The flow hole may be relatively small when considering a volume of the first inner space 522 and thus a pressure of air discharged from the first inner space 522 to the outside through the flow hole 574 may be increased. Therefore, air may be discharged to the outside of the radiation apparatus 500 through the air inlet and the air outlet disposed on an expansion line of the flow hole 574.

By the process, air introduced from the air inlet 531 may be discharged through the air outlet 532. As mentioned above, a heating element may be cooled by the vibration of the vibrating plate 550. Therefore, the inner space 520 may have a height corresponding to vibration amplitude of the vibrating plate 550 in the first direction (w1) and the second direction (w2) so that the radiation apparatus 500 having a thinner shape may be realized.

Structurally, the space utilization of the auxiliary unit 50 may be improved and power consumption and the size may be reduced when comparing with a cooling fan. Noise generated by the radiation apparatus 500 may be minimized due to the miniaturization and the improved structure.

As for the vibration of the vibrating plate 550, the magnetic circuit unit and the coil may be applied in any of the exemplary embodiments. Furthermore, the piezoelectric device 560 may be applied in any of the exemplary embodiments. Any configuration allowing the vibrating plate 550 to vibrate may be applied.

While one or more exemplary embodiments of the present disclosure have been described with reference to the figures, it will be understood by those of ordinary skill in the art that various changes in form and details may be made therein without departing from the spirit and scope of the present disclosure as defined by the following claims.

## Claims

1. A radiation apparatus comprising:
a case provided with an inner space and a vent configured to connect the inner space with the outside; and
an air circulation unit provided with a vibrating plate configured to vibrate inside the case, and configured to flow outside air by expanding or contracting the inner space by a vibration of the vibrating plate.

2. The radiation apparatus of claim 1, wherein
the air circulation comprises a magnetic circuit unit installed inside the case and configured to generate a magnetic force, and a coil provided on the vibrating plate and configured to vibrate the vibrating plate by an advance and retreat movement by acting with the magnetic circuit unit.

3. The radiation apparatus of claim 1, wherein
the inner space comprises a first inner space disposed on one side of the vibrating plate and a second inner space disposed on the other side of the vibrating plate to allow the vibrating plate to be between the first inner space and the second inner space.

4. The radiation apparatus of claim 3, wherein
the first inner space and the second inner space are alternately contracted and expanded by the vibration of the vibrating plate.

5. The radiation apparatus of claim 1, wherein
the vent comprises a first vent configured to connect the first inner space the outside and a second vent configured to connect the second inner space with the outside, wherein the first vent and the second vent are spaced apart from to each other.

6. The radiation apparatus of claim 5, wherein
the first vent and the second vent are formed to face the same direction.

7. The radiation apparatus of claim 1, wherein
the air circulation unit comprises a piezo disposed on the vibrating plate to vibrate the vibrating plate according to a contraction and an expansion of the piezo, which is contracted or expanded by applied voltage.

8. The radiation apparatus of claim 7, wherein
the vent comprises an air inlet disposed on one side of the case, and an air outlet disposed on the other side of the case.

9. The radiation apparatus of claim 8, wherein
the air circulation unit further comprises a supporting frame provided with a flow hole corresponding to the air outlet and disposed inside the case so that the vibrating plate is placed.

10. The radiation apparatus of claim 9, wherein
the inner space comprises a first inner space formed by the supporting frame and the vibrating plate, wherein air of the first inner space is discharged to the air outlet through the flow hole by the vibration of the vibrating plate.

11. The radiation apparatus of claim 9, wherein
the vibrating plate is formed of plastic materials.
